# EUROPEAN PATENT APPLICATION

(11) **EP 2 159 834 A1**
(43) Date of publication of application: **03.03.2010**
(21) Application number: 09169136.0
(22) Date of filing: 01.09.2009
(51) Int. Cl.: H01L 21/60, H01L 23/485, H01L 23/49

(54) **Conductive bond wire coating**

(71) Applicant: ABB Technology AG, 8050 Zürich (CH)
(72) Inventor: Hartmann, Samuel, 5512 Wohlenschwil (CH)
(74) Representative: ABB Patent Attorneys

(57) **Abstract**

A semiconductor device 10 comprises a conductive coating 24 that attaches a foot 14 of a bond wire 12 to a chip 18 of the semiconductor device 10, such that, even if the foot 14 of the bond 12 wire is cracked, a reliable electrical connection between the bond wire 12 and the chip 18 is maintained.

## Description

### FIELD OF THE INVENTION

The invention relates to the field of semiconductor devices. In particular, the invention relates to a semiconductor device with a chip and a bond wire, the use of a coating for attaching a foot of a bond wire to a chip of a semiconductor and a method of attaching a bond wire to a chip of a semiconductor device.

### BACKGROUND OF THE INVENTION

In many semiconductor devices, like e. g. ABB's HiPak modules, bond wire feet are coated with polyimide after a wire bonding process. The polyimide may prevent the bond wires from lifting off due to power cycling load. However, recent investigations have shown that after power cycling although the bond wires may still be attached to the chip by the polyimide, the electrical contact may not be stable. This may be because a crack may grow along a bond interface which separates the bond wire from a metallisation of a chip of the semiconductor device.

A power cycling test with an integrated gate bipolar transistor (IGBT) device showed a gate-emitter short of the IGBT chip as the life-time limiting failure mode. During the test, the failure was always located below a bond wire. In one case, it was observed that the bond wires on the IGBT that had the gate-emitter short were molten. The melting was caused by high current around 30 A or more that heated up the bond wire. However, the current per bond wire when assuming even current sharing was only around 5 A. Currents several times higher than the average may only be present, if most bond wires on the chip loose the electrical contact and the remaining intact bond wires have to carry the current for the full IGBT.

It may be that the gate-emitter short occurs due to very high current in a bond wire which then heats up the IGBT surface very locally causing mechanical stress due to the high temperature gradient. The stress then may crack the insulation (LTO) between gate and emitter.

There are two more observations during the test showing that the bond wires after power cycling at least sometimes do not provide a reliable contact anymore: After removing the polyimide many bond wires are lifting off. Further, resistance measurements between two bond wires attached on the same IGBT are not reproducible. It may be that the bond wires play a major role in the gate-emitter short failures in power cycling.

### DESCRIPTION OF THE INVENTION

It is an object of the invention to extend the lifetime of a semiconductor device.

This object is solved by the subject-matter of the independent claims. Exemplary embodiments of the invention are evident from the dependent claims.

A first aspect of the invention is a semiconductor device.

According to an embodiment of the invention, the semiconductor device comprises a chip and a bond wire. The bond wire has a foot for attaching the bond wire to the chip, wherein the foot has a coating that attaches the bond wire to the chip and wherein the coating is electrically conductive.

In other words, the semiconductor device comprises a conductive coating that attaches a foot of a bond wire to a chip of the semiconductor device, such that, even if the foot of the bond wire is cracked, a reliable electrical connection between the bond wire and the chip is maintained. Using a conductive instead of an isolative coating leads to a reliable electric contact even if the bond wire foot is fully cracked.

Wire bonding may be a method of making interconnections between an integrated circuit (IC) on the chip and a substrate, lead frame or printed circuit board during semiconductor device fabrication.

The chip may be a semiconductor chip or a die comprising junctions of a circuitry or integrated circuit.

The bond wire may be a wire comprising one single piece of a conductor, for example a wire with a single strand. Alternatively, the bond wire may comprise a plurality of conductors, for example a stranded wire comprising a bundle of single strands.

The foot of a bond wire may be an end or a part of the bond wire. The foot may be bent with respect to the remaining parts of the bond wire. The foot may be the part of the bond wire touching the chip.

The coating may be applied after the bonding of the bond wire foot. Not the whole bond wire foot has to be coated. It may suffice that the coating forms a connection around the bond wire foot between the bond wire foot and the chip metallization. The electrical conductivity of the coating may be higher than 10⁵ S/m.

According to an embodiment of the invention, the conductive material of the coating may be a solder. For example, the bond wire foot may be attached to the chip by welding and after that the foot may be covered with a solder.

According to an embodiment of the invention, the coating is electrically and/or thermally conductive. While an electrically conductive coating is adapted to bybass or to bridge a defect of the conductive path from the bond wire to the chip via the foot, a thermally conductive coating may be adapted to conduct heat generated by the resistance of the coating into the chip and/or into the bond wire. If the coating has a high electric and thermal conductivity, the coating does not get too hot.

According to an embodiment of the invention, the foot may alternatively or additionally be otherwise attached to the chip, for example by ultrasonic welding or by a pressure induced connection. For example, by pressing the foot onto the chip, due to the pressure, the material of the foot may bond to a metal material of the chip.

According to an embodiment of the invention, the semiconductor device is a high power semiconductor device. A high power may be a current of more than 75 A and/or a voltage over 1.000 V. The integrated circuit or the circuitry on the chip may be adapted to switch such high currents and high voltages.

According to an embodiment of the invention, the semiconductor device comprises a further bond wire with a further foot for attaching the further bond wire to the chip. For example, the semiconductor device may comprise a plurality of bond wires. Some of the plurality of bond wires may be connected to different terminals of the chip and/or some other of the plurality of bond wires may be attached to the same terminal for distributing an electrical load onto different bond wires.

According to an embodiment of the invention, the coating is a continuous coating covering the foot and the further foot. For example, the coating is in the form of a layer on the chip and the foot and the further foot are covered by the layer. For example, the whole active area of a terminal of the semiconductor chip may be covered with a layer that embeds all the bond wire feet attached to this active area. For example, the layer may be 1 mm thick. This may have the advantage, that if the coating has a low electrical conductivity, even in this case, the overall conductivity of the layer is as high such that the current can be conducted by the layer despite cracks in some of the bond feet.

The continuous coating may be a coating that is an integral formed body covering the foot and the further foot or a plurality of foots. For example, the coating may be a layer of one single material on the chip.

According to an embodiment of the invention, the bond wire is a single wire. For example, the bond wire may be a single strand of a metal material that is attached to the chip. If the semiconductor device comprises a plurality of bond wires, the plurality of bond wires all may be a single wire or only some of the plurality of bond wires may be single wires.

According to an embodiment of the invention, the bond wire is a litz wire. A litz wire may be a special type of wire that comprises many thin wires that are twisted or woven together. For example, all bond wires of the semiconductor device may be litz wires. For example, a first bond wire may be a single wire and a second bond wire may be a litz wire. However, it is also possible, that some of the bond wires are single wires and others are litz wires. A litz wire may be very flexible and may have the advantage that it does not create high stress that destructs the bond wire attachment during a cyclic load.

According to an embodiment of the invention, the litz wire is a flat litz wire. A flat litz wire may be a litz wire that is braided or interwoven in such a way, that the litz wire forms a band. One end of the flat litz wire may be a flat foot which may be covered by a coating that is not very high. In this way, very compact fail-save connections may be formed.

According to an embodiment of the invention, the coating comprises a compound with metal particles in a polymer matrix, for example an epoxy resin blended with a metal powder. In this way, due to the metal powder, a high conductivity of the coating can be provided.

According to an embodiment of the invention, the metal powder comprises silver.

According to an embodiment of the invention, the coating may comprise a silver-filled epoxy compound. A silver-filled epoxy compound may be a paste containing the optimum ratio of silver powder to epoxy resin for maximal thermal and electrical conductivity and mechanical strength.

A silver-filled epoxy compound may have the following characteristics: a high electric and thermal conductivity, a good adhesion to aluminium, a low elastic modulus and not too high thermal expansion and high mechanical strength for that the material is stable in power cycling. For example, the silver filled epoxy may be Plaskon® SE3001 from Cookson Group with an electric conductivity of 106 S/m and a thermal conductivity of 4 W/(m*K).

According to an embodiment of the invention, the coating is adapted not to influence the chemical properties of the bond wire and the chip. In particular, the coating does not decrease the reliability of the semiconductor device by chemical effects. For example, the coating does not corrode the metallization of the chip or the coating does not inhibit the silicone gel curing.

According to an embodiment of the invention, the coating is dispensable. A dispensable coating may surround the foot completely during the coating process and may form a good contact between the coating and the foot and between the coating and the chip.

According to an embodiment of the invention, the coating comprises an adhesive. For example, a conductive adhesive is used to glue a flat litz wire on the chip metallization. It has to be understood, that the conductivity of the adhesive may be enhanced, if the adhesive is blended with a metal powder, for example a silver powder.

According to an embodiment of the invention, the chip comprises an insulated gate bipolar transistor and/or a diode. The integrated circuit formed on the chip may comprise a circuitry that is adapted to switch high currents and/or high voltages.

According to an embodiment of the invention, the semiconductor device further comprises a substrate, wherein the chip is soldered to the substrate and the bond wire is bonded to the chip. In this case, the bond wire may not be soldered to the chip but otherwise attached. This opens the possibility that the substrate soldering is done during a different step than the attaching of the bond wire to the chip. Applying the coating material after the substrate soldering step may widen the range of suitable material for the coating. For example, the material of the coating may only have to be stable at an operating temperature of the semiconductor device and may not have to be stable at the temperature of the soldering process.

According to an embodiment of the invention, the chip is low temperature bonded to substrate. It is possible to use a low temperature bonding instead or additionally to soldering.

In the manufacturing process of ABB's HiPack modules, the terminals are soldered in the same step as the substrates. A thermal stability of the coating up to 250°C would allow applying the coating material before or during substrate soldering. However, it may be more convenient to do the terminal bonding later in a separate process, for example with ultrasonic welding.

A further aspect of the invention is a use of an electrical conductive coating for attaching a foot of a bond wire to a chip of a semiconductor device, such as one of the semiconductor devices described above and below, in particular a high power semiconductor device.

A further aspect of the invention is a method of attaching a bond wire to a chip of a semiconductor device, for example one of the semiconductor devices described above and below.

According to an embodiment of the invention, the method comprises the steps of:
setting a foot of the bond wire onto the first surface of the chip; applying a coating to the foot such that the foot is attached to the chip, wherein the coating is electrically conductive. In particular, for each or some of its terminals, the chip may comprise a metal pad or metallization on one surface and the foot is set onto this surface.

According to an embodiment of the invention, the method further comprises the steps of: setting a further foot of a further bond wire onto the surface of the chip; applying the coating to the foot and the further foot such that a continuous coating is formed on the chip, the continuous coating attaching the foot and the further foot to the chip. For example, the continuous coating or a layer of material of the coating may cover most of a metal pad or an attaching area of the chip.

For example, in a first step all bond wires are bonded to the chip and in a second step all the feet of the bond wires are coated.

According to an embodiment of the invention, the method further comprises the step of:
soldering the chip to a substrate of the semiconductor device before applying the coating. As already said, this may have the advantage that the coating only has to withstand the operating temperature of the semiconductor device but not the soldering temperature.

According to an embodiment of the invention, the method further comprises the step of:
soldering the substrate to a base plate. After the bonding, a plurality of substrates may be soldered to a base plate. For example, a semiconductor device may comprise up to six substrates. It may be possible that the bonding takes place after the soldering of the substrate to the base plate.

According to an embodiment of the invention, the method further comprises the step of:
attaching the foot of the bond wire to the chip by welding, for example ultrasonic welding. As a rule, the welding of the bond wire foot to the chip is done before the coating.

For example, in a first step the chip may be soldered to the substrate and in a second step after the semiconductor device has cooled down from the soldering temperature, the foot or a plurality of feet is set to the metallization on the surface of the chip of a terminal of the chip and after that in a third step, the foot or the feet are cast into the electrically conductive coating.

### BRIEF DESCRIPTION OF THE DRAWINGS

The subject matter of the invention will be explained in more detail in the following text with reference to exemplary embodiments which are illustrated in the attached drawings.

Fig. 1 shows a cross-sectional view of a bond wire attached to a chip according to an exemplary embodiment of the invention.

Fig. 2 shows a section of semiconductor device according to an embodiment of the invention.

Fig. 3 and Fig. 4 show a schematic three-dimensional view of a bond wire foot attached to a chip according to an exemplary embodiment of the invention.

Fig. 5 shows a schematically cross-sectional view of bond wires attached to a chip according to an exemplary embodiment of the invention.

Fig. 6 shows a flow diagram of a method for attaching a bond wire to a chip according to an exemplary embodiment of the invention.

Fig. 7 schematically shows the current flow through the coating according to an embodiment of the invention.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

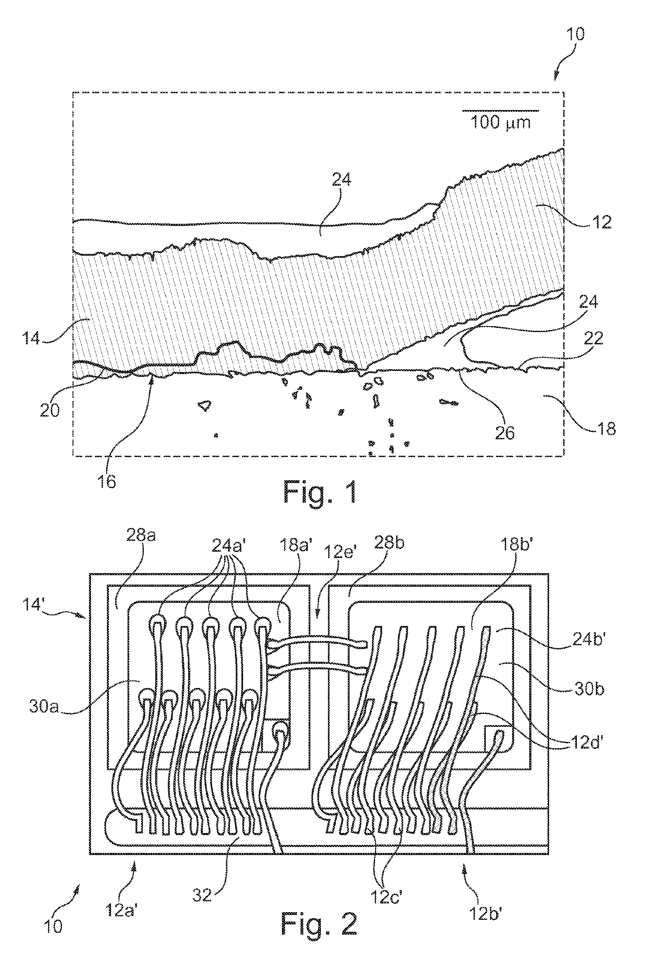

Fig. 1 shows a cross-sectional view of a semiconductor device 10 with a bond wire 12. A foot 14 of the bond wire 12 is attached to a chip 18 of the semiconductor device 10. The foot 14 touches the chip 18 in a touching area 16 and in case the foot 14 of the bond wire is able to conduct an electrical current, the electrical current flows through the touching area 16. However, due to a power cycling load, the foot 14 of the bond wire 12 may become a crack 20 inhibiting the flow of the electrical current. As a rule such a crack 20 may only have a diameter of only a few micrometers. However, due to the crack or gap 20, the bond wire 12 does not touch the surface 22 of the chip 18 and the foot 14 of bond wire 12 is not able to conduct a significant current.

The foot 14 of the bond wire 12 is covered with an electrically conductive coating 24. Although, the foot 14 of the bond wire 12 does not touch the surface 22 of the chip 18, there is an electrically conductive path connecting the bond wire 12 with the chip 18. The current flowing through the bond wire 12 may enter the chip in the covering area 26 in which the coating 24 is touching or bonding with the surface 22 of the chip 18.

Fig. 2 shows a section of a further embodiment of a semiconductor device 10 with two chips 18a' and 18b'. Each of the chips 18a' and 18b' may, for example, comprise an IGBT. The two chips 18a' and 18b' are soldered to a substrate 28a and 28b, respectively, of the semiconductor device 10. Each of the chips 18a' and 18b' is attached to a plurality of bond wires 12a', 12b'. Each of the bond wires 12a', 12b' is at its one end are attached to metallization or metal pad 30a, 30b on the surface of the chips 18a' and 18b', respectively, and at its other end is attached to a lead frame 32 of the semiconductor device 10. Usually, additionally to the IGBT chips 18a' and 18b', diodes - freewheeling diodes - are connected antiparallel to the IGBTs.

The bond wires 12e' are connecting the two chips 18a, 18b. One end or foot of each bond wire 12c' is attached to the metal pad 30a of the chip 18a', the other end or foot of the bond wire 12c' is attached to the metal pad 30b of the chip 18b'.

All the feet 14' of the bond wires 12a', 12b', 12e' are touching metal pads or metallizations 30a, 30b of the chips 18a' and 18b' and are covered or cast into an electrically conductive coating 24a', 24b'. The feet 14' of the bond wires 14a' on the chip 18a' each have an individual coating 24a'. The coatings 24a' of two bond wires 14a' do not overlap.

The coating 24b' for the feet 14' of the bond wires 12b' is a continuous coating. The coating 24b' is a layer of an electrically conductive material nearly almost covering the metal pad 30b of the chip 18b'. As can be seen from Fig. 2, some of the bond wires 12b' are single bond wires 12c', others are flat litz wires 12d'.

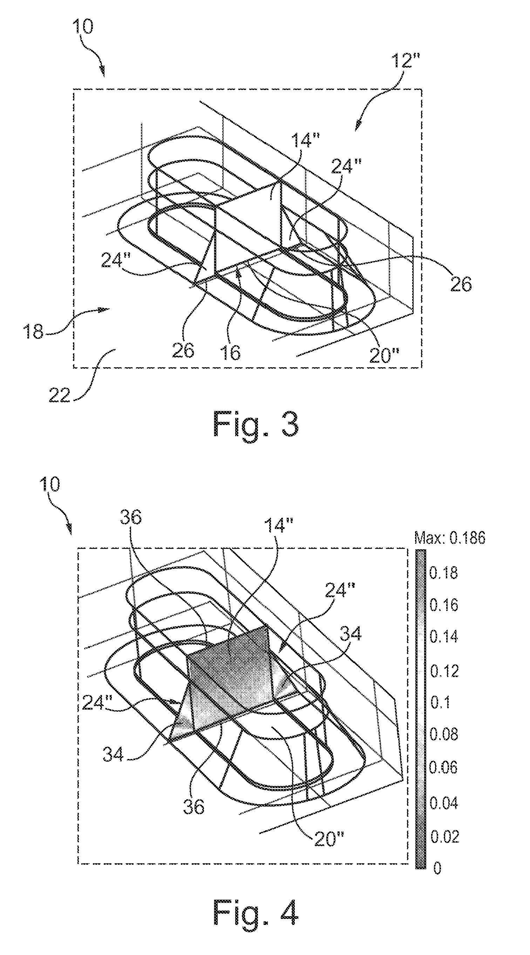

Fig. 3 shows a schematic three-dimensional view of a foot 14" of a bond wire 12". The foot 14" doesn't touch the surface 22 of the chip 18 due to a crack 20". Therefore, a direct current flow between the bond wire 12" to the chip 18 is not or nearly not possible. However, the bond wire 12" is at its feet 14" covered with a conductive coating 24". The conductive coating 24" has a substantially triangular cross-section, wherein a first side of the triangle is in contact with one side of the bond wire foot 14" and a second side of the triangle is in contact with the surface 22 of the chip 18. The conductive coating 24" bridges or bypasses the crack 20" and allows a current flow from the bond wire 12" to the chip 18 indirectly. The bond wire foot 14" has the dimensions 300 µm x 300 µm x 1000 µm with the crack 20" of 10 µm separating the bond wire foot 14" from the chip surface 22. The conductive material or coating 24" wets the chip along a width of 100 µm (the second side of the triangle) and the bond foot along a width of 200 µm (the first side of the triangle).

Fig. 4 shows a schematic three-dimensional view of the semiconductor device 10 of Fig. 3 and shows the temperature distribution in the bond wire foot 14" and the conductive coating 24". The temperature distribution has been calculated with a simulation. The material properties of the foot 14" are taken from Matweb for the Plaskon® SE3001. A current of 10 A is applied to the bond wire foot 14" while the chip surface 22 is set to ground potential (lower boundary of the conductive coating 24").

Fig. 4 shows the temperature increase in the conductive coating 24" by self-heating due to a current flow. The maximum temperature increase is below 0.2 K and thus no degradation of the coating due to self-heating can be expected. The electric resistance of the electric path via the coating is 0.23 mΩ. This is ten times smaller than the electric resistance of a 15 mil (0.38 mm) aluminium bond wire of 10 mm length. Even a coating material 24" with ten times lower electrical conductivity would work. The simulation shows that available materials have a sufficient high electrical conductivity, to carry or conduct the electric current without heating.

As can be seen from Fig. 4, the points of maximal temperature 34 differ in temperature from the points with minimal temperature 36 only by less than 0.2 K. Hence, even if the electrically conductive coating 24" is the only electrical connection between the bond wire 12" and the chip 18, it provides a reliable electrical coupling.

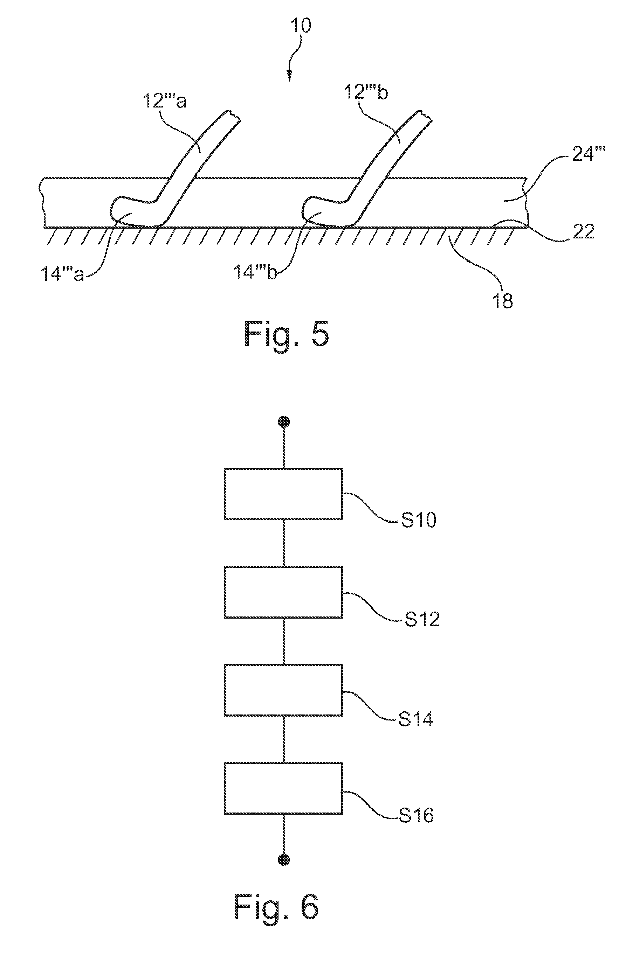

Fig. 5 shows a schematic cross-sectional view of a further embodiment of a semiconductor device 10. The semiconductor device 10 comprises at least two bond wires 12a"' and 12b"' that are attached to a chip 18 via their feet 14a'" and 14b"'.

The foot 14a"' like the foot 14b'" extends parallel to the surface 22 of the chip 18. All the parts of the bond wires 12a"' and 12b"' extending substantially parallel to the surface 22 are completely covered by a continuous coating 24"'. Even in the case, when the continuous coating 24"' has a low specific conductivity, the overall conductivity of the continuous coating 24'" is high enough to lead the current from the bond wires 12a"' and 12b"' to the chip 18 even in the case when some or all of the bond wire feet 14a"' and 14b"' do not touch the surface 22 of the chip 18.

Fig. 6 shows a flow diagram of a manufacturing method of the semiconductor device 10. The method is described with respect to Fig. 1 but may also be applied for manufacturing the devices of Fig. 2 to Fig. 5.

In a step S10, the chip 18 is soldered to substrate 28a of the semiconductor device 10. In a step S12, a bond wire 12 is set on the surface 22 of the chip 18 so that a foot 14 for attaching the bond wire to the chip 18 is generated. For example, the bond wire 12 may be a single stranded wire that is pressed against the surface 22 such that the end 14 of the single stranded bond wire is bent and a foot 14 is formed. It is also possible that the bond wire 12 is a flat litz wire 12d' that is set onto the surface 22.

In an optional step S 14, the bond wire 12 may be ultrasonic welded to the surface 22 of the chip 18. Alternatively or additionally, the foot 14 of the bond wire 12 may be soldered to the surface 22 of the chip.

In a step S16, an electrically conductive coating 24 is applied to the foot 14, such that the foot is covered with the electrically conductive coating 24 and the electrically conductive coating 24 forms an electrically conductive bridge from the bond wire 18 to the chip 18. In the case, the semiconductor device 10 comprises a plurality of bond wires 14', it is possible, that individual coatings 24a' are formed or that a continuous coating 24b' is formed to cover the feet 14' of bond wires 18b'.

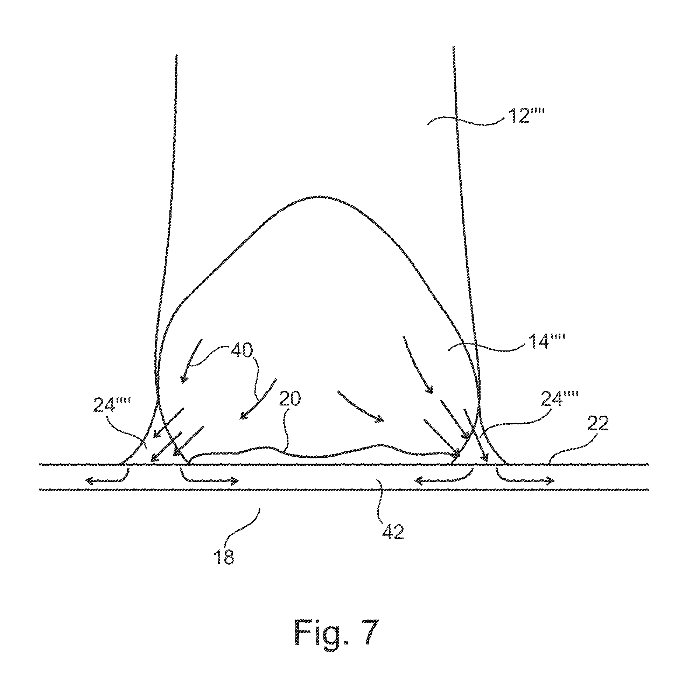

Fig. 7 schematically shows a current flow 40 through a coating 24"" solely surrounding the base of the foot 14"". Due to the crack 20, the current 40 solely flows through the coating 24"" and enters the chip metallization 42.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- 10: semiconductor device
- 12: bond wire
- 14: foot
- 16: touching area
- 18: chip
- 20: crack
- 22: surface of chip
- 24: coating
- 26: covering area
- 12a': bond wires
- 12b': bond wires
- 12c': single stranded bond wire
- 12d': flat litz wire
- 12e': bond wires
- 14': feet of bond wires
- 18a': chip
- 18b': chip
- 24a': individual coating
- 24b': continuous coating
- 28a: substrate
- 28b: substrate
- 30a: metal pad
- 30b: metal pad
- 32: lead frame
- 12": bond wire
- 14": foot
- 20": crack
- 24": coating
- 34: maximal temperature
- 36: minimal temperature

- 12a'": bond wire
- 12b'": bond wire

- 14a"': bond wire foot
- 14b'": bond wire foot
- 24"': coating

- 12"": bond wire
- 14"": bond wire foot
- 24"": coating
- 40: current flow
- 42: chip metallization

## Claims

1. A semiconductor device (10) comprising:
a chip (18),
a bond wire (12), the bond wire (12) having a foot (14) for attaching the bond wire (12) to the chip (18),
wherein the foot (14) has a coating (24) that attaches the bond wire (12) to the chip (18),
wherein the coating (24) is electrically conductive.

2. The semiconductor device (10) of claim 1,
wherein the semiconductor device (10) is a high power semiconductor device (10).

3. The semiconductor device (10) of claim 1 or 2, further comprising:
a further bond wire (12b"') with a further foot (14b"') for attaching the further bond wire (12b"') to the chip (18),
wherein the coating is a continuous coating (24"') covering the foot (14a"') and the further foot (14b"').

4. The semiconductor device (10) of one of the preceding claims,
wherein the bond wire is a single wire (12c').

5. The semiconductor device (10) of one of the preceding claims,
wherein the bond wire is a litz wire (12d').

6. The semiconductor device (10) of one of the preceding claims,
wherein the coating (24) comprises a compound with metal particles in a polymer matrix, for example an epoxy resin blended with a metal powder.

7. The semiconductor device (10) of claim 6,
wherein the metal powder comprises silver.

8. The semiconductor device (10) of one of the preceding claims,
wherein the coating (24) comprises an adhesive.

9. The semiconductor device (10) of one of the preceding claims,
wherein the chip (18a', 18b') comprises an insulated gate bipolar transistor.

10. The semiconductor device (10) of one of the preceding claims, further comprising:
a substrate (28a);
wherein the chip (18a') is soldered to the substrate (28a) and the bond wire (14a') is welded to the chip (18a').

11. A use of an electrically conductive coating (24) for attaching a foot (14) of a bond wire (12) to a chip (18) of a semiconductor device (10).

12. A method of attaching a bond wire (12) to a chip (18) of a semiconductor device (10), the method comprising the steps of:
Setting a foot (14) of the bond wire (12) onto the surface (22) of the chip (18);
Applying a coating (24) to the foot (14) such that the foot (14) is attached to the chip (18),
wherein the coating (24) is electrically conductive.

13. The method of claim 12, further comprising the steps of:
Setting a further foot (14b"') of a further bond wire (12b"') onto the surface (22) of the chip (18);
Applying the coating (24"') to the foot (14a"') and the further foot (14b"') such that a continuous coating (24"') is formed on the chip (18), the continuous coating attaching the foot (14a"') and the further foot (14b"') to the chip (18).

14. The method of claim 12 or 13, further comprising the steps of:
Soldering the chip (18) to a substrate (28a) of the semiconductor device (10) before applying the coating (24);
Soldering the substrate (28a) to a base plate.

15. The method of one of the claims 12 to 14, further comprising the step of:
Attaching the foot (14) of the bond wire (12) to the chip (18) by welding.
